# EUROPEAN PATENT APPLICATION

(11) **EP 4 772 596 A1**
(43) Date of publication of application: **08.07.2026**
(21) Application number: 24859309.7
(22) Date of filing: 31.07.2024
(51) Int. Cl.: C09K 5/10

(54) **COMPOSITION FOR HEAT TRANSFER FLUID, HEAT TRANSFER FLUID, HEAT TRANSFER DEVICE, AND HEAT TRANSFER METHOD**

(30) Priority: 31.08.2023 JP 2023141585; 19.04.2024 JP 2024068666
(71) Applicant: DAIKIN INDUSTRIES, LTD., Osaka-Shi, Osaka 530-0001 (JP)
(72) Inventor: MARI, Daichi, Osaka-Shi, Osaka 530-0001 (JP); SHIRAI, Atsushi, Osaka-Shi, Osaka 530-0001 (JP); MATSUURA, Makoto, Osaka-Shi, Osaka 530-0001 (JP)
(74) Representative: Hoffmann Eitle
(86) International application number: PCT/JP2024/027349
(87) International publication number: WO 2025/047267

(57) **Abstract**

The present invention provides a composition for heat transfer fluid, the composition comprising:
a hexafluoropropene trimer represented by C₉F₁₈; and
perfluorotripropylamine.

## Description

### TECHNICAL FIELD

The present disclosure relates to a composition for heat transfer fluid, a heat transfer fluid, a heat transfer apparatus, and a heat transfer method.

### BACKGROUND ART

It is known that hexafluoropropene (HFP) trimers are usable as heat transfer fluid (PTL 1).

Having low global warming potential (GWP) and low toxicity, HFP trimers have been receiving attention as a replacement for chlorofluorocarbon (CFC) and hydrochlorofluorocarbon (HCFC).

### CITATION LIST

### PATENT LITERATURE

PTL 1: Japanese National Patent Publication No. 2020-514420

### SUMMARY OF INVENTION

### TECHNICAL PROBLEM

Although hexafluoropropene trimers have low GWP, they have high boiling points, and therefore it is difficult to use them at high temperatures.

The present invention aims at providing a heat transfer fluid suitable for use at relatively high temperatures.

### SOLUTION TO PROBLEM

The present disclosure includes below-described aspects.
[1] A composition for heat transfer fluid, the composition comprising:
   a hexafluoropropene trimer represented by C₉F₁₈; and
   perfluorotripropylamine.
[2] The composition for heat transfer fluid according to [1] above, wherein the hexafluoropropene trimer includes at least one of hexafluoropropene trimers represented by formulae (1) to (111) below. 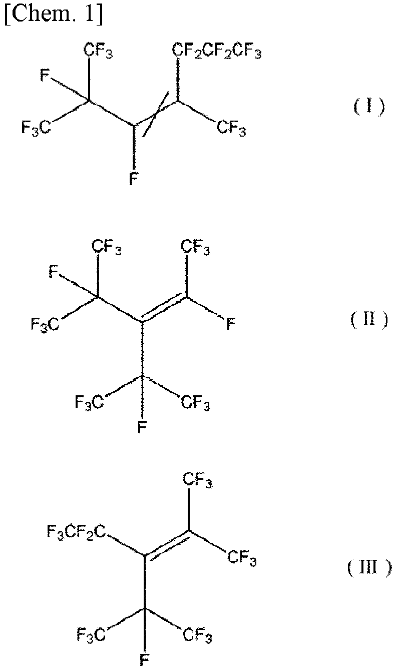
[3] The composition for heat transfer fluid according to [1] or [2] above, wherein a mass ratio between the hexafluoropropene trimer represented by C₉F₁₈ and the perfluorotripropylamine is from 0.1:99.9 to 99.9 to 0.1.
[4] The composition for heat transfer fluid according to [2] or [3] above, wherein a compound represented by the formula (I) is contained in less than 85 mass% relative to a total amount of compounds represented by the formulae (I) to (III).
[5] The composition for heat transfer fluid according to [2] or [3] above, wherein a compound represented by the formula (I) is contained in not less than 50 mass% and less than 85 mass% relative to a total amount of compounds represented by the formulae (I) to (III).
[6] The composition for heat transfer fluid according to [2] or [3] above, wherein a compound represented by the formula (I) is contained in 85 mass% or more relative to a total amount of the hexafluoropropene trimer.
[7] The composition for heat transfer fluid according to any one of [1] to [5] above, wherein a total amount of the hexafluoropropene trimer represented by C₉F₁₈ and the perfluorotripropylamine is 80 mass% or more relative to the composition for heat transfer fluid.
[8] The composition for heat transfer fluid according to any one of [1] to [7] above, wherein the composition is a quasi-azeotropic liquid.
[9] The composition for heat transfer fluid according to any one of [1] to [8] above, wherein the composition is usable in a semiconductor production process.
[10] A heat transfer fluid comprising the composition for heat transfer fluid according to any one of [1] to [9] above.
[11] The heat transfer fluid according to [10] above, further comprising a stabilizer.
[12] The heat transfer fluid according to [10] or [11] above usable in a semiconductor production process.
[13] Use of the composition for heat transfer fluid according to any one of [1] to [9] above or the heat transfer fluid according to any one of [10] to [12] above for transferring heat.
[14] A heat transfer apparatus comprising:
   a device; and
   a mechanism for transferring heat to the device or from the device, wherein the mechanism comprises the composition for heat transfer fluid according to any one of [1] to [9] above or the heat transfer fluid according to any one of [10] to [12] above.
[15] The heat transfer apparatus according to [14] above, wherein the device is a wafer for use in semiconductor production.
[16] A semiconductor production apparatus comprising the heat transfer apparatus according to [14] or [15] above.
[17] A heat transfer method comprising:
   preparing a device; and
   transferring heat to the device or from the device by using the composition for heat transfer fluid according to any one of [1] to [9] above or the heat transfer fluid according to any one of [10] to [12] above.
[18] The heat transfer method according to [17] above, wherein the device is a wafer for use in semiconductor production.

### ADVANTAGEOUS EFFECTS OF INVENTION

The present disclosure provides a heat transfer fluid suitable for use at relatively high temperatures.

### BRIEF DESCRIPTION OF DRAWINGS

[Fig. 1] Fig. 1 shows results of vapor-liquid equilibrium simulation of a mixture of the compound represented by the formula (I) and perfluorotripropylamine.
[Fig. 2] Fig. 2 shows results of vapor-liquid equilibrium simulation of a mixture of the compound represented by the formula (II) and perfluorotripropylamine.
[Fig. 3] Fig. 3 shows results of vapor-liquid equilibrium simulation of a mixture of the compound represented by the formula (III) and perfluorotripropylamine.

### DESCRIPTION OF EMBODIMENTS

In the present specification, a numerical range "(from) A to B" is intended to include both the lower limit numerical value and the upper limit numerical value. In other words, a numerical range "(from) A to B" means not less than A and not more than B.

In the following, a description will be given of a composition for heat transfer fluid according to the present disclosure.

### (Composition for Heat Transfer Fluid)

The composition for heat transfer fluid according to the present disclosure contains a hexafluoropropene trimer represented by C₉F₁₈ and perfluorotripropylamine.

The hexafluoropropene trimer represented by C₉F₁₈ has a low pour point and a low kinematic viscosity at low temperatures and therefore it is suitable for use at low temperatures; however, due to its low boiling point, it is difficult to use it at high temperatures. On the other hand, perfluorotripropylamine has a high boiling point and therefore it is suitable for use at high temperatures; however, due to its high pour point and high kinematic viscosity at low temperatures, it is difficult to use it at low temperatures. The composition for heat transfer fluid according to the present disclosure has low GWP, and its boiling point and its kinematic viscosity are well balanced. Moreover, the composition for heat transfer fluid according to the present disclosure may have excellent stability. In addition, the composition for heat transfer fluid according to the present disclosure is quasi-azeotropic, and therefore it is excellent in handleability and maintainability.

The hexafluoropropene trimer represented by C₉F₁₈ is not limited and may be a compound having any structure represented by C₉F₁₈.

In a preferred aspect, the hexafluoropropene trimer includes at least one of hexafluoropropene trimers represented by formulae (I) to (III) below.

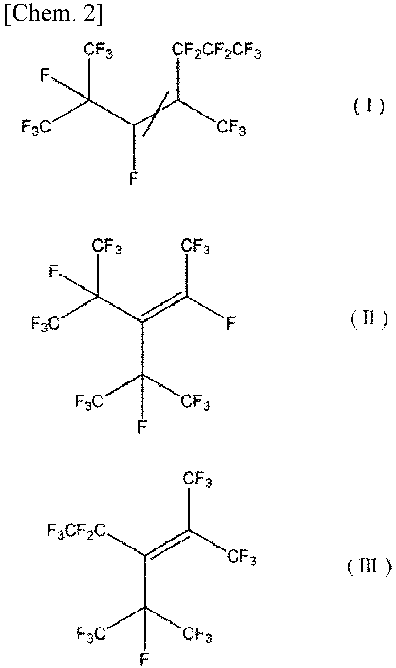

Herein, the compound represented by the formula (I) includes both E- and Z-diastereomers unless otherwise specified.

The hexafluoropropene trimer contained in the composition for heat transfer fluid according to the present disclosure may be only one of the compounds represented by the formulae (I) to (III), or may be a mixture of two or three of them.

In the composition for heat transfer fluid according to the present disclosure, the compound represented by the formula (I) may be contained in 99 mass% or less relative to the total amount of the compounds represented by the formulae (I) to (III), preferably in 90 mass% or less, more preferably in 85 mass% or less, further preferably in less than 85 mass%, further more preferably in 80 mass% or less, and, for example, it may be contained in 75 mass% or less, or in 70 mass% or less, or in 65 mass% or less, or in 60 mass% or less. When the content of the compound represented by the formula (I) is relatively low, the boiling point of the composition for heat transfer fluid is relatively high. In other words, the vapor pressure of the composition for heat transfer fluid is relatively low. On the other hand, if the vapor pressure of the composition for heat transfer fluid is relatively high, vaporization tends to be facilitated, and, for example, in the case where the composition is used in a semiconductor production apparatus, leakage from the apparatus may be significant. The composition for heat transfer fluid according to the present disclosure has a low vapor pressure, and therefore leakage from the apparatus is reduced, which is advantageous from the environmental and economic standpoints.

In the composition for heat transfer fluid according to the present disclosure, the compound represented by the formula (I) may be preferably contained in 1 mass% or more relative to the total amount of the compounds represented by the formulae (I) to (III), preferably in 10 mass% or more, more preferably in 30 mass% or more, further more preferably in 45 mass% or more, particularly preferably in 50 mass% or more, and, for example, it may be contained in 60 mass% or more, or in 65 mass% or more, or in 75 mass% or more, or in 85 mass% or more. When the content of the compound represented by the formula (I) is relatively high, the kinematic viscosity is relatively low, and, for example, in the case where the composition for heat transfer fluid is used in a semiconductor production apparatus, the pressure required for circulating the composition can be relatively small. When the pressure required for circulating the composition for heat transfer fluid is relatively small, pressure loss can be reduced and leakage from the apparatus can also be reduced, which leads to reduction of operational costs.

In the composition for heat transfer fluid according to the present disclosure, the compound represented by the formula (I) may be contained in, for example, 1 mass% to 99 mass% relative to the total amount of the compounds represented by the formulae (I) to (III), or in 10 mass% to 90 mass%, or in 30 mass% to 90 mass%, or in 10 mass% to 85 mass%, or in 35 mass% to 85 mass%, or in not less than 10 mass% and less than 85 mass%, or in not less than 20 mass% and less than 85 mass%, or in not less than 30 mass% and less than 85 mass%, or in not less than 40 mass% and less than 85 mass%, or in not less than 50 mass% and less than 85 mass%, or in 40 mass% to 80 mass%, or in 55 mass% to 80 mass%, or in 60 mass% to 75 mass%, or in 65 mass% to 70 mass%, or in 35 mass% to 60 mass%, or in 50 mass% to 60 mass%, preferably in 30 mass% to 90 mass%, preferably in not less than 40 mass% and less than 85 mass%, more preferably in 40 mass% to 80 mass%, further preferably in 45 mass% to 70 mass%, further more preferably in 50 mass% to 60 mass%.

The mass ratio between the compound represented by the formula (II) and the compound represented by the formula (III) in the composition for heat transfer fluid according to the present disclosure is not limited, and, for example, it may be from 1:9 to 9:1, or from 2:8 to 8:2, or from 3:7 to 7:3, or from 4:6 to 6:4, or from 4.5:5.5 to 5.5:4.5.

The compounds represented by the formulae (I) to (III) can be produced by a conventional procedure, and examples of the procedure include, but not limited to, a method described in WO2018/172919. Moreover, the compounds can be obtained by trimerization of hexafluoropropenes by a conventional procedure.

In the composition for heat transfer fluid according to the present disclosure, the mass ratio between the hexafluoropropene trimer represented by C₉F₁₈ and the perfluorotripropylamine is preferably from 0.1:99.9 to 99.9:0.1, more preferably from 1:99 to 99:1, further preferably from 5:95 to 95:5, and, for example, it may be from 10:90 to 90:10, or from 20:80 to 80:20, or from 30:70 to 70:30, or from 40:60 to 60:40, or from 45:55 to 55:45.

The total amount of the hexafluoropropene trimer represented by C₉F₁₈ and the perfluorotripropylamine may be preferably 80 mass% or more relative to the composition for heat transfer fluid, more preferably 85 mass% or more, further preferably 90 mass% or more, and, for example, it may be 95 mass% or more, or 98 mass% or more, or 99 mass% or more, or 99.9 mass% or more. The total amount of the hexafluoropropene trimer represented by C₉F₁₈ and the perfluorotripropylamine may be substantially 100 mass% relative to the composition for heat transfer fluid. In other words, the heat transfer fluid according to the present disclosure may be a mixture of the hexafluoropropene trimer represented by C₉F₁₈ and perfluorotripropylamine.

The composition for heat transfer fluid according to the present disclosure may be a quasi-azeotropic liquid. In the case where the composition for heat transfer fluid is a quasi-azeotropic liquid, the composition for heat transfer fluid does not undergo significant compositional changes even when it is vaporized, and therefore it has enhanced handleability.

Herein, the quasi-azeotropic liquid means a liquid where the molar fraction of each of the components of the quasi-azeotropic liquid in the gas phase differs by 10% or less from that in the liquid phase.

The composition for heat transfer fluid according to the present disclosure can be obtained by mixing the hexafluoropropene trimer and the perfluorotripropylamine in a certain proportion. The composition for heat transfer fluid according to the present disclosure may be a mixture of the hexafluoropropene trimer compound and the perfluorotripropylamine that are mixed in advance, or a mixture of them that are mixed immediately before use.

The composition for heat transfer fluid according to the present disclosure may contain a hexafluoropropene trimer represented by C₉F₁₈ other than the compounds represented by the formulae (1) to (111).

The composition for heat transfer fluid according to the present disclosure may contain a hexafluoropropene dimer.

The hexafluoropropene dimer may include (E)-1,1,1,2,3,4,5,5,5-nonafluoro-4-(trifluoromethyl)-2-pentene, (Z)-1,1,1,2,3,4,5,5,5-nonafluoro-4-(trifluoromethyl)-2-pentene, or 1,l,3,4,4,5,5-nonafluoro-2-(trifluoromethyl)-2-pentene.

The composition for heat transfer fluid according to the present disclosure may contain a hexafluoropropene tetramer.

The hexafluoropropene tetramer may include 1,1,1,2,5,6,6,6-octafluoro-2,3,5-tris(trifluoromethyl)-4-(perfluoropropyl-2-yl)-3-hexene.

The composition for heat transfer fluid according to the present disclosure contains CₘF₂ₘ and/or CₙF₍₂ₙ₋₂₎ [where m is an integer of 4 to 12 except 9, and n is an integer of 4 to 12], in addition to the hexafluoropropene trimer.

m is an integer of 4 or more, preferably an integer of 5 or more, more preferably an integer of 6 or more. Moreover, n is an integer of 12 or less, preferably an integer of 11 or less, more preferably an integer of 10 or less. It should be noted that m does not include 9.

n is an integer of 4 or more, preferably an integer of 5 or more, more preferably an integer of 6 or more. Moreover, n is an integer of 12 or less, preferably an integer of 11 or less, more preferably an integer of 10 or less. Particularly preferably, n is 9.

CₘF₂ₘ may be either a chain compound or a cyclic compound that may have a substituted structure. The chain compound may be a so-called alkene, and it may be either linear or branched.

CₙF₍₂ₙ₋₂₎ may be either a chain compound or a cyclic compound that may have a substituted structure. The chain compound may be a so-called diene or alkyne, and it may be either linear or branched.

When containing both CₘF₂ₘ and/or CₙF₍₂ₙ₋₂₎ and the hexafluoropropene trimer, the composition for heat transfer fluid according to the present disclosure has enhanced functions as a composition for heat transfer fluid. Moreover, when the composition for heat transfer fluid according to the present disclosure contains CₘF₂ₘ and/or CₙF₍₂ₙ₋₂₎, stability of the hexafluoropropene trimer is enhanced.

The content of CₘF₂ₘ and/or CₙF₍₂ₙ₋₂₎ in the composition for heat transfer fluid according to the present disclosure may be preferably 10 mass% or less, more preferably 5 mass% or less, further preferably 1 mass% or less. Moreover, the content of CₘF₂ₘ and/or CₙF₍₂ₙ₋₂₎ in the composition for heat transfer fluid according to the present disclosure may be preferably 0.0001 mass% or more, more preferably 0.001 mass% or more. It should be noted that CₘF₂ₘ and/or CₙF₍₂ₙ₋₂₎ is not an essential component of the composition for heat transfer fluid according to in the present disclosure, and may or may not be contained.

The composition for heat transfer fluid according to the present disclosure may further contain perfluoropolyether, a methoxytridecafluoroheptene isomer mixture, perfluorotributylamine, and the like.

The perfluoropolyether is preferably represented by the general formula:

RO-Rf¹-R'

where
R and R' are the same as or different from each other and each is a monovalent group represented by -CₘF₂ₘ₊₁, in which m is an integer of 1 to 8, and
Rf¹ is a divalent fluoropolyoxyalkylene group containing 2 to 20 repeating units, in which the repeating unit is represented by:
   (i) -CFXO- (where X is F or CF₃);
   (ii) -CF₂CFXO- (where X is F or CF₃);
   (iii) -CFXCF₂O- (where X is F or CF₃);
   (iv) -CF₂CF₂CF₂O-; or
   (v) -CF₂CF₂CF₂CF₂O-, or
Rf¹ is a divalent group represented by:
   (vi) -(CF₂)ₙ-CFY-O- (where n is an integer of 0 to 3, Y is a monovalent group represented by the general formula -ORf²Z, Rf² is a divalent fluoropolyoxyalkylene group containing 2 to 20 repeating units represented by-CFXO-, -CF₂CFXO-, -CF₂CF₂CF₂O-, or -CF₂CF₂CF₂CF₂O-, Xs are the same as or different from each other and each is F or CF₃, and Z is a monovalent C₁₋₅ perfluoroalkyl group).

Specific examples of the perfluoropolyether include products under the trade names GALDEN (registered trademark) "HT135" and GALDEN (registered trademark) "HT110" (both manufactured by Solvay), and the like.

Specifically, the methoxytridecafluoroheptene isomer mixture includes methyl-perfluoroheptene ether (MPHE) (C₇F₁₃OCH₃). Specific examples include a product under the trade name "Opteon SF10" (manufactured by Chemours) and the like.

When the composition for heat transfer fluid according to the present disclosure contains perfluoropolyether and a methoxytridecafluoroheptene isomer mixture, the content ratio of these components does not substantially affect the heat transfer fluid properties of the entire composition for heat transfer fluid because these components have similar heat transfer fluid properties to those of the compound represented by C₉F₁₈. Therefore, in this case, the composition for heat transfer fluid according to the present disclosure preferably contains the compound represented by C₉F₁₈ in 40 mass% to 99.9 mass%, more preferably 60 mass% to 99.9 mass%, further preferably 80 mass% to 99.9 mass%, relative to the entire composition for heat transfer fluid.

The composition for heat transfer fluid according to the present disclosure may further contain water. The content of water in the composition for heat transfer fluid is 1 ppm by mass or more, preferably 5 ppm by mass or more. When the content of water is set to a certain level or more, such as 1 ppm by mass or more, for example, electrification of the composition for heat transfer fluid that can occur when the composition for heat transfer fluid becomes less stable can be reduced. Moreover, the content of water in the composition for heat transfer fluid is 1000 ppm by mass or less, preferably 500 ppm by mass or less, more preferably 100 ppm by mass or less, yet further preferably 20 ppm by mass or less. When the content of water is set to a certain level or less, such as 1000 ppm by mass or less, for example, degradation of the HFP trimer represented by C₉F₁₈ during heating can be reduced and thereby an increase of fluoride ions and a rise of acidity can be reduced.

In one aspect, the content of water relative to the total amount of the compound represented by C₉F₁₈ regarded as 100 parts by mass is preferably 0.0001 parts by mass or more, more preferably 0.0005 parts by mass or more, further preferably 0.001 parts by mass or more.

Moreover, the content of water relative to the total amount of the compound represented by C₉F₁₈ regarded as 100 parts by mass is preferably 10 parts by mass or less, more preferably 5 parts by mass or less, further preferably 1 part by mass or less.

The composition for heat transfer fluid according to the present disclosure may further contain fluoride ions. The amount of fluoride ions in the composition for heat transfer fluid is preferably 0.000001 mass% or more, more preferably 0.00001 mass% or more, relative to the entire composition for heat transfer fluid.

Moreover, the amount of fluoride ions contained in the composition for heat transfer fluid according to the present disclosure is preferably 5 mass% or less, more preferably 1 mass% or less, further preferably 0.1 mass% or less, particularly preferably 0.01 mass% or less, particularly further preferably 0.001% or less, relative to the entire composition for heat transfer fluid.

The fluoride ions are not limited and may be selected from a wide range of known fluoride ions. Specific examples include those from hydrogen fluoride, sodium fluoride, sodium hydrogen fluoride, potassium fluoride, potassium hydrogen fluoride, lithium fluoride, cesium fluoride, calcium fluoride, magnesium fluoride, aluminum fluoride, zinc fluoride, silver fluoride, and iron fluoride. Only one type of them may be contained, or a plurality of types of them may be contained.

The kinematic viscosity of the composition for heat transfer fluid according to the present disclosure at -50°C may be preferably 20.0 cSt or less, more preferably 16.0 cSt or less, further preferably 12.0 cSt or less, further more preferably 11.0 cSt or less, particularly preferably 10.0 cSt. Moreover, the kinematic viscosity of the composition for heat transfer fluid according to the present disclosure at -50°C may be 1.0 cSt or more, and, for example, it may be 5.0 cSt or more, or 8.0 cSt or more.

The kinematic viscosity of the composition for heat transfer fluid according to the present disclosure at -50°C can be measured with an Ubbelohde viscometer in accordance with JIS K 2283.

The boiling point of the composition for heat transfer fluid according to the present disclosure may be preferably more than 110°C, more preferably 112°C or more, further preferably 113°C or more, further more preferably 115°C or more, particularly preferably 118°C or more, particularly more preferably 120°C or more. Moreover, the boiling point of the composition for heat transfer fluid according to the present disclosure may be 125°C or less, for example.

### (Heat Transfer Fluid)

The heat transfer fluid according to the present disclosure may contain other components, in addition to the composition for heat transfer fluid according to the present disclosure. In one aspect, the composition for heat transfer fluid, itself, may be a heat transfer fluid. In another aspect, the composition for heat transfer fluid contains other components.

Other components contained in the heat transfer fluid according to the present disclosure in addition to the composition for heat transfer fluid may be any components as long as they do not interfere with the effect and the purpose of the present disclosure. Examples of these other components include water, a stabilizer, and the like.

The stabilizer exhibits stabilizing effects and thereby it functions as a so-called acid scavenger or antioxidant. Examples of major stabilizing effects include effects to capture radicals produced in the system to prevent degradation of the hexafluoropropene trimer, acid scavenging effects to capture acids produced in the system to prevent further degradation of the hexafluoropropene trimer due to acid, and the like.

The stabilizer may be selected from a wide range of known stabilizers. Among these, preferably, for effectively reducing metal corrosion caused by the composition, one or more types of stabilizers selected from the group consisting of unsaturated alcohol-based stabilizers, nitro-based stabilizers, amine-based stabilizers, phenol-based stabilizers, and epoxy-based stabilizers are used.

The unsaturated alcohol-based stabilizer may be selected from a wide range of known ones. For example, one or more selected from the group consisting of 3-buten-2-ol, 2-buten-1-ol, 4-propen-1-ol, 1-propen-3-ol, 2-methyl-3-buten-2-ol, 3-methyl-3-buten-2-ol, 3-methyl-2-buten-1-ol, 2-hexen-1-ol, 2,4-hexadien-1-ol, and oleyl alcohol can be used.

The nitro-based stabilizer may be selected from a wide range of known ones. As aliphatic nitro compounds, nitromethane, nitroethane, 1-nitropropane, 2-nitropropane, and the like may be mentioned, for example. As aromatic nitro compounds, one or more selected from the group consisting of nitrobenzene, o-, m-, and p-dinitrobenzenes, o-, m-, and p-nitrotoluenes, dimethylnitrobenzene, m-nitroacetophenone, o-, m-, and p-nitrophenols, o-nitroanisole, m-nitroanisole, and p-nitroanisole can be used, for example.

The amine-based stabilizer may be selected from a wide range of known ones. For example, one or more selected from the group consisting of pentylamine, hexylamine, diisopropylamine, diisobutylamine, di-n-propylamine, diallylamine, triethylamine, N-methylaniline, pyridine, morpholine, N-methylmorpholine, triallylamine, allylamine, α-methylbenzylamine, dimethylamine, trimethylamine, ethylamine, diethylamine, triethylamine, propylamine, isopropylamine, dipropylamine, tripropylamine, butylamine, isobutylamine, dibutylamine, tributylamine, dipentylamine, tripentylamine, 2-ethylhexylamine, aniline, N,N-dimethylaniline, N,N-diethylaniline, ethylenediamine, propylenediamine, diethylenetriamine, tetraethylenepentamine, benzylamine, dibenzylamine, diphenylamine, and diethylhydroxylamine can be used.

The phenol-based stabilizer may be selected from a wide range of known ones. For example, one or more selected from the group consisting of 2,6-di-tert-butyl-4-methylphenol, 3-cresol, phenol, 1,2-benzenediol, 2-isopropyl-5-methylphenol, and 2-methoxyphenol can be used.

The epoxy-based stabilizer may be selected from a wide range of known ones. For example, one or more selected from the group consisting of butylene oxide, 1,2-propylene oxide, 1,2-butylene oxide, butyl glycidyl ether, diethylene glycol diglycidyl ether, and 1,2-epoxy-3-phenoxypropane can be used.

Use of a combination of stabilizers with different stabilizing effects can more effectively prevent degradation of the hexafluoropropene trimer that can occur from various causes, and therefore, it is preferable to use one or more selected from the group consisting of the epoxy-based stabilizers, the unsaturated alcohol-based stabilizers, the nitro-based stabilizers, and the phenol-based stabilizers mentioned above.

From the viewpoint of effectively reducing acid release from the hexafluoropropene trimer to reduce metal corrosion caused by the liquid composition, the content of the stabilizer in the entire heat transfer fluid is preferably 0.0001 mass% or more, more preferably 0.01 mass% or more. On the other hand, in consideration of avoiding undesired changes of the physical properties of the heat transfer fluid due to excessive addition of stabilizers, the content of the stabilizer in the entire heat transfer fluid is preferably 10 mass% or less, more preferably 5 mass% or less.

### (Use of Composition for Heat Transfer Fluid or Heat Transfer Fluid)

The composition for heat transfer fluid and the heat transfer fluid according to the present disclosure are used for drawing heat away from various heat transfer targets or supplying heat to heat transfer targets. Examples of the heat transfer target according to the present disclosure include articles, apparatuses, and atmospheres that are to be cooled to, heated to, or maintained at an intended temperature. Examples of the heat transfer target include electric components, machine components, and optical components, as well as those after processing and those after assembly. Specific, nonlimiting examples of the heat transfer target according to the present disclosure include wafers used for producing semiconductor devices, microprocessors, power control semiconductors, electric branch switches, power transformers, circuit boards, multi-chip modules, mounted and non-mounted semiconductor devices, chemical reactors, nuclear reactors, fuel cells, lasers, missile components, and the like.

The composition for heat transfer fluid or the heat transfer fluid according to the present disclosure is accompanied by a relatively small pressure loss at the time of circulation of the composition during use, and therefore suitable for applications where a large amount of heat needs to be transferred. In a preferred aspect, the composition for heat transfer fluid or the heat transfer fluid according to the present disclosure is used in a semiconductor production process. In a semiconductor production process, the heat transfer target is a wafer used for producing a semiconductor device.

The composition for heat transfer fluid or the heat transfer fluid according to the present disclosure is usable for two-phase immersion cooling and as chiller fluid and Rankine cycle working fluid.

Within a device designed to transfer heat by using the composition for heat transfer fluid or the heat transfer fluid according to the present disclosure, the composition for heat transfer fluid or the heat transfer fluid according to the present disclosure can be used to replace the heat transfer fluid in use in the device.

The composition for heat transfer fluid or the heat transfer fluid according to the present disclosure can be a drop-in replacement, a nearly drop-in replacement, or a retrofit replacement for the heat transfer fluid in use. "A drop-in replacement" means a replacement without requiring any changes to the device. "A nearly drop-in replacement" means a replacement requiring only few changes to the device. "A retrofit replacement" means a replacement requiring minimal changes (namely, not requiring extensive changes) to the device. Preferably, the composition for heat transfer fluid or the heat transfer fluid according to the present disclosure can be a drop-in replacement or a nearly drop-in replacement for the above-mentioned heat transfer fluid.

Determination that use as a drop-in replacement, a nearly drop-in replacement, or a retrofit replacement is possible can be made when all the following conditions are satisfied.
(i) The boiling point of the heat transfer fluid is at least about 80% or more, preferably at least about 85% or more, of the boiling point of the predecessor heat transfer fluid.
(ii) The pour point of the heat transfer fluid is equal to or less than the pour point of the predecessor heat transfer fluid.
(iii) The kinematic viscosity of the heat transfer fluid is at least about 200% or less, preferably at least about 150% or less, of the kinematic viscosity of the predecessor heat transfer fluid.
(iv) The heat transfer fluid is compatible with the predecessor heat transfer fluid at a freely-selected proportion.

When the boiling point of the composition for heat transfer fluid or the heat transfer fluid according to the present disclosure is designed to be at least about 80% or more, preferably at least about 85% or more, of the boiling point of the predecessor heat transfer fluid, occurrence of cavitation and leakage from the apparatus can be reduced. The upper limit to the boiling point of the heat transfer fluid is not limited, and, for example, it may be at least about 130% or less of the boiling point of the predecessor heat transfer fluid.

When the pour point of the composition for heat transfer fluid or the heat transfer fluid according to the present disclosure is designed to be equal to or less than the pour point of the predecessor heat transfer fluid, use at a temperature less than the conventional operational temperature is possible and, thereby, the operational temperature range can be extended. The upper limit to the pour point of the heat transfer fluid is not limited, and, for example, it may be at most 30°C higher than the pour point of the predecessor heat transfer fluid.

When the kinematic viscosity of the composition for heat transfer fluid or the heat transfer fluid according to the present disclosure is designed to be at least about 200% or less, preferably at least about 150% or less, of the kinematic viscosity of the predecessor heat transfer fluid, an increase of power consumption can be reduced or power consumption can be reduced. Comparison of the kinematic viscosity is preferably performed in terms of the kinematic viscosity at the operational temperature, but this is not limitative, and the comparison can be performed in terms of the kinematic viscosity at a temperature from -20°C to -40°C, for example, and more specifically, it can be performed at -20°C.

When the composition for heat transfer fluid or the heat transfer fluid according to the present disclosure is compatible with the predecessor heat transfer fluid at a freely-selected proportion, replacing operation is easier to carry out.

Furthermore, when the following conditions are satisfied, the composition for heat transfer fluid or the heat transfer fluid according to the present disclosure is more suitable as a drop-in replacement, a nearly drop-in replacement, or a retrofit replacement.
(v) The composition for heat transfer fluid or the heat transfer fluid according to the present disclosure has a dielectric constant that is 120% or less of that of the predecessor heat transfer fluid.
(vi) The composition for heat transfer fluid or the heat transfer fluid according to the present disclosure has a dielectric strength that is 90% or more of that of the predecessor heat transfer fluid.
(vii) The composition for heat transfer fluid or the heat transfer fluid according to the present disclosure has a specific heat that is 90% or more of that of the predecessor heat transfer fluid.
(viii) The composition for heat transfer fluid or the heat transfer fluid according to the present disclosure has a thermal conductivity that is 90% or more of that of the predecessor heat transfer fluid.

When having a dielectric constant designed to be 120% or less of the dielectric constant of the predecessor heat transfer fluid, the composition for heat transfer fluid or the heat transfer fluid according to the present disclosure can be suitably used as a replacement composition. The lower limit to the dielectric constant of the heat transfer fluid is not limited, and, for example, it may be 80% or more of the dielectric constant of the predecessor heat transfer fluid.

When having a dielectric strength designed to be 90% or more of the dielectric strength of the predecessor heat transfer fluid, the composition for heat transfer fluid or the heat transfer fluid according to the present disclosure can be suitably used as a replacement composition. The upper limit to the dielectric strength of the heat transfer fluid is not limited, and, for example, it may be 120% or less of the dielectric strength of the predecessor heat transfer fluid.

When having a specific heat designed to be 90% or more of the specific heat of the predecessor heat transfer fluid, the composition for heat transfer fluid or the heat transfer fluid according to the present disclosure can be suitably used as a replacement composition. The upper limit to the specific heat of the heat transfer fluid is not limited, and, for example, it may be 120% or less of the specific heat of the predecessor heat transfer fluid.

When having a thermal conductivity designed to be 90% or more of the thermal conductivity of the predecessor heat transfer fluid, the composition for heat transfer fluid or the heat transfer fluid according to the present disclosure can be suitably used as a replacement composition. The upper limit to the thermal conductivity of the heat transfer fluid is not limited, and, for example, it may be 120% or less of the thermal conductivity of the predecessor heat transfer fluid.

The boiling point of the composition for heat transfer fluid or the heat transfer fluid according to the present disclosure is measured by DSC (differential scanning calorimetry), as a temperature at which an endothermic peak is observed while the temperature is being raised from 25°C at 5°C/minute.

The pour point of the composition for heat transfer fluid or the heat transfer fluid according to the present disclosure is measured by DSC, as a temperature at which an endothermic peak is observed while the temperature is being raised at 5°C/minute after lowered with liquid nitrogen to the coagulation point or less.

The dielectric constant of the composition for heat transfer fluid or the heat transfer fluid according to the present disclosure is a value at a frequency of 1 kHz measured by a capacitance method in an environment at a temperature of 25°C and a humidity of 60%.

The kinematic viscosity and the density of the composition for heat transfer fluid or the heat transfer fluid according to the present disclosure can be measured with a kinematic viscometer, SVM3001, manufactured by Anton Paar.

The dielectric strength of the composition for heat transfer fluid or the heat transfer fluid according to the present disclosure is the breakdown voltage measured at the time when a liquid specimen is made to enter into the gaps between spherical electrodes aligned at regular intervals and then the voltage is raised at a steady rate. Measurement conditions are as described below.
Electrode shape: Spherical (φ12.5 mm)
Intervals between electrodes: 2.5 mm
Pressure-raising rate: 2 kV/second
Atmosphere of measurement: Air (22°C, 57%RH)

The specific heat of the composition for heat transfer fluid or the heat transfer fluid according to the present disclosure is a value obtained by DSC under conditions described below.
Measurement apparatus: Differential scanning calorimeter DSC8500 manufactured by Perkin-Elmer
Temperature raising rate: 10°C/minute
Reference specimen: Sapphire (-Al2O3)
Atmosphere: In dry nitrogen stream
Specimen container: Hermetically sealed aluminum container

The thermal conductivity of the composition for heat transfer fluid or the heat transfer fluid according to the present disclosure is a value obtained by a transient hot-wire method.

The compatibility of the composition for heat transfer fluid or the heat transfer fluid according to the present disclosure is determined by checking if it is compatible with a target solvent when mixed. Herein, "being compatible" means that the two are mixed uniformly, in other words, phase separation does not occur.

### (Heat Transfer Apparatus)

The present disclosure further provides a heat transfer apparatus comprising a device and a mechanism for transferring heat to the device or from the device, wherein the mechanism comprises the above-mentioned composition for heat transfer fluid or the above-mentioned heat transfer fluid.

The device may be a component, a workpiece, an assembly, and/or the like that is to be cooled, heated, or maintained at a certain temperature or within a certain temperature range. The device may be an electric component, a machine component, and/or an optical component, and examples thereof include wafers for use in semiconductor production, semiconductor devices, computers, server computers, servers including blade servers; disk array/storage systems; storage area networks; network-attached storages; storage communications systems; workstations; routers; telecommunications infrastructures/switches; wired, optical, and wireless communications apparatuses; cell processing apparatuses; printers; power source apparatuses; displays; optical apparatuses; measurement systems including hand-held systems; military electronic devices; chemical reactors; fuel cells; heat exchangers; electrochemical cells; microprocessors; power control semiconductors; switchboard apparatuses; transformers; circuit boards; multi-chip modules; packaged and non-packaged semiconductor devices; lasers; and the like, and preferable among them is a wafer for use in semiconductor production.

Semiconductor devices are heat-generating devices to be mounted on the device, such as CPUs, GPUs, SSDs, and the like, for example, and a semiconductor device is made of a single element such as silicon and germanium, a compound semiconductor such as gallium arsenide (GaAs), gallium phosphide (GaP), indium phosphide (InP), gallium nitride (GaN), and silicon carbide (SiC), and/or the like, for example.

When the device is a server computer, one logic board or a plurality of logic boards are accommodated in the internal space. The logic board comprises many heat-generating electronic components including at least one processor such as CPU and/or GPU. In addition to them, other heat-generating components for computers such as those listed below, for example, can be used: chipsets; memories, graphics chips, network chips, RAMs, power source apparatuses, daughter cards; and storage drives such as solid state drives and mechanical hard drives.

The heat transfer apparatus is a heat transfer apparatus that transfers heat to and from a heat transfer target by using the above-mentioned heat transfer fluid, and the supplying and receiving heat (heat transfer) is performed through thermal contact with the heat transfer target. For example, drawing heat away from the heat transfer target is cooling, and supplying heat is heating. Different mechanisms may be used for cooling and heating, respectively, or a singe heat transfer apparatus may be used for both cooling and heating.

The heat transfer apparatus is not limited and, for example, it may be a pump, a valve, a fluid containment system, a pressure control system, a cooler, a heat exchanger, a heat source, a heat sink, a refrigeration system, an active temperature control system, a passive temperature control system, and/or the like.

More specific examples of the heat transfer apparatus include a temperature-controlled wafer chuck installed inside a plasma enhanced chemical vapor deposition (PECVD) tool, a temperature-controlled test head for die performance testing, a temperature-controlled workspace inside a semiconductor process device, a reservoir for thermal shock test bath liquid, a thermostatic chamber, and the like, and preferable among them is a temperature-controlled workspace inside a semiconductor process device.

The heat transfer target to be brought into thermal contact with the heat transfer apparatus is as described above.

The present disclosure also provides a semiconductor production apparatus comprising the heat transfer apparatus according to the present disclosure.

### (Heat Transfer Method)

The present disclosure discloses a heat transfer method comprising a step of preparing a device, and a step of transferring heat to the device or from the device with the use of the above-mentioned composition for heat transfer fluid or heat transfer fluid. Here, the heat transfer apparatus is placed in thermal contact with the device so as to make heat transfer possible. When placed in thermal contact with the device, the heat transfer apparatus can draw heat away from the device, or supply heat to the device, or maintain the device at a selected temperature or within a selected temperature range. The direction of heat flow (from the device or to the device) depends on the relative temperature difference between the device and the heat transfer apparatus.

Thus far, the present invention is described, but the present invention is not limited to what is described above and can be implemented in various configurations without departing from the gist of the present invention.

### Examples

In the following, the present disclosure will be described by way of examples, but the scope of the present disclosure is not limited to these examples.

### (Production of Hexafluoropropene Trimer)

### (Production Example 1)

Based on a method described in Chem Ber (1973), vol. 106, pp 2950-2959, a hexafluoropropene trimer was obtained. The HFP trimer thus obtained was purified by distillation for removal of impurities such as hexafluoropropene dimers and tetramers. The purified HFP trimer was distillated and thereby separated into compounds represented by the formulae (I), (II), and (III).

The compounds represented by the formulae (I), (II), and (III) thus obtained were mixed in such a manner that the ratio between the compounds represented by the formulae (I), (II), and (III) became as specified in the table below, and thereby trimer mixtures 1 to 5 were obtained.

**[Table 1]**

| Trimer mixture | Formula (I) | | Formula (II) | Formula (III) |
|---|---|---|---|---|
| 1 | 3 mass% | | 33 mass% | 64 mass% |
| 2 | 99.5 mass% | | 0.2 mass% | 0.3 mass% |
| 3 | 52 mass% | | 16 mass% | 32 mass% |
| 4 | 78 mass% | | 9 mass% | 13 mass% |
| 5 | 90 mass% | | 5 mass% | 5 mass% |

### (Perfluorotripropylamine)

As perfluorotripropylamine, FC-3283 manufactured by 3M was prepared.

### (Example 1)

The trimer mixture 1 and the perfluorotripropylamine were mixed in a mass ratio of 50:50 to form a composition for heat transfer fluid of Example 1.

### (Example 2)

The trimer mixture 2 and the perfluorotripropylamine were mixed in a mass ratio of 50:50 to form a composition for heat transfer fluid of Example 2.

### (Example 3)

The trimer mixture 2 and the perfluorotripropylamine were mixed in a mass ratio of 75:25 to form a composition for heat transfer fluid of Example 3.

### (Example 4)

The trimer mixture 3 and the perfluorotripropylamine were mixed in a mass ratio of 50:50 to form a composition for heat transfer fluid of Example 4.

### (Example 5)

The trimer mixture 3 and the perfluorotripropylamine were mixed in a mass ratio of 75:25 to form a composition for heat transfer fluid of Example 5.

### (Example 6)

The trimer mixture 4 and the perfluorotripropylamine were mixed in a mass ratio of 50:50 to form a composition for heat transfer fluid of Example 6.

### (Example 7)

The trimer mixture 4 and the perfluorotripropylamine were mixed in a mass ratio of 75:25 to form a composition for heat transfer fluid of Example 7.

### (Example 8)

The trimer mixture 5 and the perfluorotripropylamine were mixed in a mass ratio of 50:50 to form a composition for heat transfer fluid of Example 8.

### (Example 9)

The trimer mixture 5 and the perfluorotripropylamine were mixed in a mass ratio of 75:25 to form a composition for heat transfer fluid of Example 9.

### (Vapor-Liquid Equilibrium Simulation)

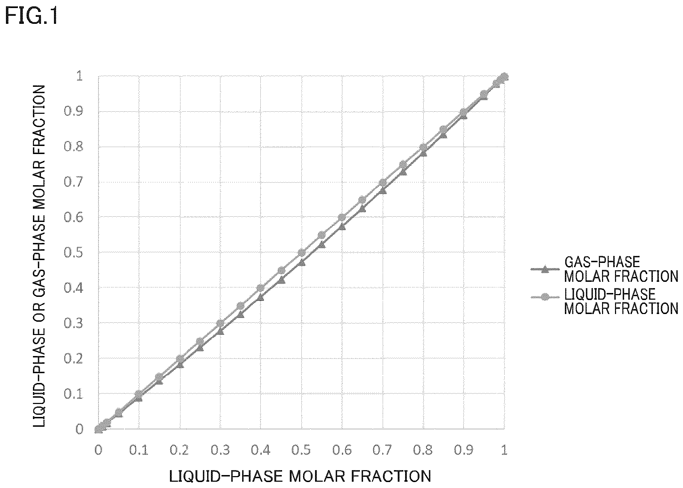

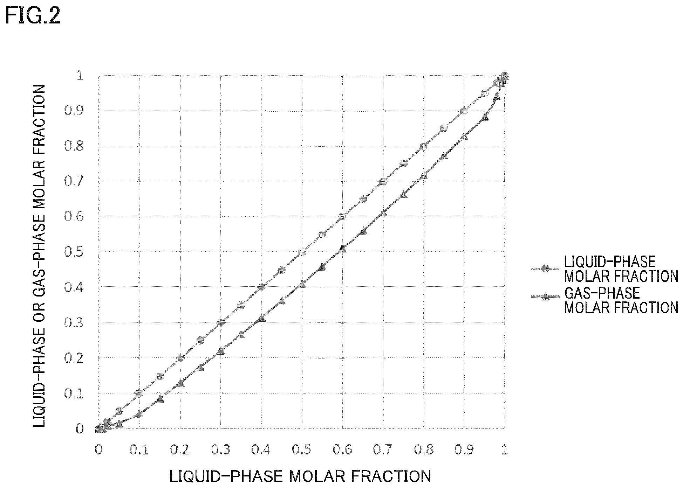

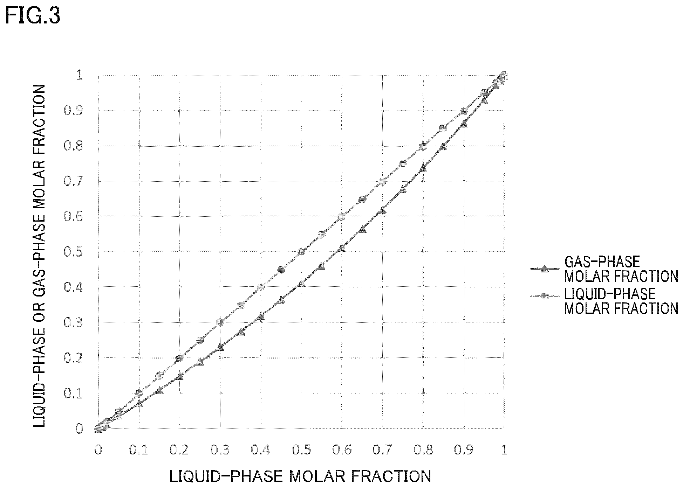

Mixtures of the perfluorotripropylamine and respective one of the compounds represented by the formulae (I) to (III) according to the present disclosure were subjected to vapor-liquid equilibrium simulation performed with the use of COSMOtherm under atmospheric pressure. Results are given in Figs. 1 to 3, which show the liquid-phase molar fraction and the gas-phase molar fraction of the compounds represented by the formulae (I) to (III). From the results, it was demonstrated that each of the compounds was in an quasi-azeotropic relationship with the perfluorotripropylamine.

### (Measurement of Boiling Point, Kinematic Viscosity, and Dielectric Constant)

The boiling point was measured by DSC, as a temperature at which an endothermic peak was observed while the temperature was being raised from 25°C at 5°C/min. The kinematic viscosity was a value at -50°C measured in accordance with JIS K 2283 with an Ubbelohde viscometer. The dielectric constant was a value at a frequency of 1 kHz measured by a capacitance method in an environment at a temperature of 25°C and a humidity of 60%. The resulting measured values are given in Table 1 below.

**[Table 2]**

| | | Boiling point (°C) | Kinematic viscosity (cSt) | Dielectric constant |
|---|---|---|---|---|
| Ex. 1 | (Trimer mixture 1):perfluorotripropylamine=50:50 | 124 | 16.0 | 2.0 |
| Ex. 2 | (Trimer mixture 2):perfluorotripropylamine=50:50 | 118 | 11.0 | 2.0 |
| Ex. 3 | (Trimer mixture 2):perfluorotripropylamine=75:25 | 112 | 9.0 | 2.0 |
| Ex. 4 | (Trimer mixture 3):perfluorotripropylamine=50:50 | 123 | 13.7 | 2.0 |
| Ex. 5 | (Trimer mixture 3):pcrfluorotripropylaminc=75:25 | 118 | 12.0 | 2.0 |
| Ex. 6 | (Trimer mixture 4):perfluorotripropylamine=50:50 | 119 | 12.6 | 2.0 |
| Ex. 7 | (Trimer mixture 4):perfluorotripropylamine=75:25 | 113 | 10.7 | 2.0 |
| Ex. 8 | (Trimer mixture 5):perfluorotripropylamine=50:50 | 118 | 11.8 | 2.0 |
| Ex. 9 | (Trimer mixture 5):perfluorotripropylamine=75:25 | 112 | 9.8 | 2.0 |
| Ref. Ex. 1 | Trimer mixture 1 | 112 | 14.0 | 2.0 |
| Ref. Ex. 2 | Trimer mixture 2 | 105 | 6.7 | 2.0 |
| Ref. Ex. 3 | Trimer mixture 3 | 110 | 10.0 | 2.0 |
| Ref. Ex. 4 | Trimer mixture 4 | 105 | 8.5 | 2.0 |
| Ref. Ex. 5 | Trimer mixture 5 | 105 | 7.5 | 2.0 |
| Ref. Ex. 6 | Perfluorotripropylamine | 128 | 22.0 | 1.9 |

From the above results, it was demonstrated that each of Examples 1 to 9 exhibited a higher boiling point and a lower kinematic viscosity than the weighted average for the mixing ratio.

### INDUSTRIAL APPLICABILITY

The composition for heat transfer fluid and the heat transfer fluid according to the present disclosure are suitable for use in various applications where heat needs to be transferred, particularly suitable for use in the process of semiconductor production.

## Claims

1. A composition for heat transfer fluid, the composition comprising:
a hexafluoropropene trimer represented by C₉F₁₈; and
perfluorotripropylamine.

2. The composition for heat transfer fluid according to claim 1, wherein the hexafluoropropene trimer includes at least one of hexafluoropropene trimers represented by formulae (I) to (III) below.

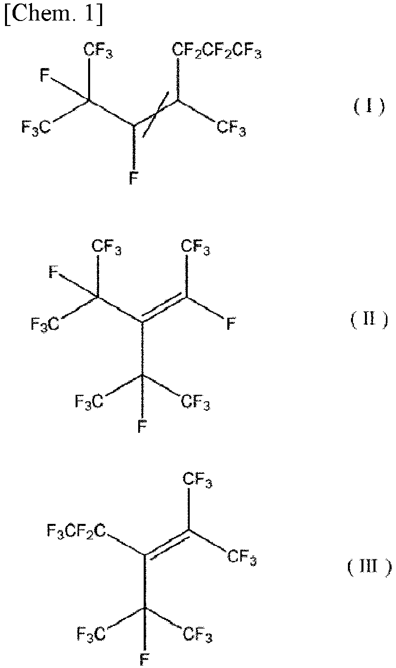

3. The composition for heat transfer fluid according to claim 1 or 2, wherein a mass ratio between the hexafluoropropene trimer represented by C₉F₁₈ and the perfluorotripropylamine is from 0.1:99.9 to 99.9 to 0.1.

4. The composition for heat transfer fluid according to claim 2 or 3, wherein a compound represented by the formula (I) is contained in less than 85 mass% relative to a total amount of compounds represented by the formulae (I) to (III).

5. The composition for heat transfer fluid according to any one of claims 2 to 4, wherein a compound represented by the formula (I) is contained in not less than 50 mass% and less than 85 mass% relative to a total amount of compounds represented by the formulae (I) to (III).

6. The composition for heat transfer fluid according to any one of claims 2 to 5, wherein a compound represented by the formula (I) is contained in 85 mass% or more relative to a total amount of the hexafluoropropene trimer.

7. The composition for heat transfer fluid according to any one of claims 1 to 6, wherein a total amount of the hexafluoropropene trimer represented by C₉F₁₈ and the perfluorotripropylamine is 80 mass% or more relative to the composition for heat transfer fluid.

8. The composition for heat transfer fluid according to any one of claims 1 to 7, wherein the composition is a quasi-azeotropic liquid.

9. The composition for heat transfer fluid according to any one of claims 1 to 8, wherein the composition is usable in a semiconductor production process.

10. A heat transfer fluid comprising the composition for heat transfer fluid according to any one of claims 1 to 9.

11. The heat transfer fluid according to claim 10, further comprising a stabilizer.

12. The heat transfer fluid according to claim 10 or 11 usable in a semiconductor production process.

13. Use of the composition for heat transfer fluid according to any one of claims 1 to 9 or the heat transfer fluid according to any one of claims 10 to 12 for transferring heat.

14. A heat transfer apparatus comprising:
a device; and
a mechanism for transferring heat to the device or from the device, wherein the mechanism comprises the composition for heat transfer fluid according to any one of claims 1 to 9 or the heat transfer fluid according to any one of claims 10 to 12.

15. The heat transfer apparatus according to claim 14, wherein the device is a wafer for use in semiconductor production.

16. A semiconductor production apparatus comprising the heat transfer apparatus according to claim 14 or 15.

17. A heat transfer method comprising:
preparing a device; and
transferring heat to the device or from the device by using the composition for heat transfer fluid according to any one of claims 1 to 9 or the heat transfer fluid according to any one of claims 10 to 12.

18. The heat transfer method according to claim 17, wherein the device is a wafer for use in semiconductor production.
